# EUROPEAN PATENT APPLICATION

(11) **EP 1 758 157 A1**
(43) Date of publication of application: **28.02.2007**
(21) Application number: 05750991.1
(22) Date of filing: 17.06.2005
(51) Int. Cl.: H01L 21/52, C08L 13/00

(54) **RESIN PASTE FOR DIE BONDING AND ITS USE**

(30) Priority: 18.06.2004 JP 2004180959
(71) Applicant: Hitachi Chemical Co., Ltd., Shinjuku-ku, Tokyo 163-0449 (JP)
(72) Inventor: HASEGAWA,Yuji c/o HITACHI CHEMICAL CO.,LTD, Ibaraki 317-8555 (JP); KIKUCHI, Tooru c/o HITACHI CHEMICAL CO., LTD, Ibaraki 317-8555 (JP); EBANA, Satoshi c/o HITACHI CHEMICAL CO., LTD., Ibaraki 317-8555 (JP); ODAGAWA, Yasuhisa c/o HITACHI CHEMICAL CO., LTD., Ibaraki 317-8555 (JP); KAWASUMI, Masao c/o HITACHI CHEMICAL CO., LTD., ibaraki 317-8555 (JP); YAMAZAKI, Mitsuo c/o HITACHI CHEMICAL CO., LTD., ibaraki 317-8555 (JP)
(74) Representative: HOFFMANN EITLE
(86) International application number: PCT/JP2005/011140
(87) International publication number: WO 2005/124851

(57) **Abstract**

Disclosed is a resin paste for die bonding comprising a butadiene homopolymer or copolymer (A) having a carboxylic acid terminal group, a thermosetting resin (B), a filler (C), and a printing solvent (D), wherein the elastic modulus of the resin paste following drying and curing is within a range from 1 to 300 MPa (25°C). The solid fraction is preferably from 40 to 90% by weight, the thixotropic index is preferably from 1.5 to 8.0, and the viscosity (25°C) is preferably from 5 to 1,000 Pa·s. Using this resin paste, a semiconductor device is produced by a method comprising (1) applying a predetermined quantity of the resin paste to a substrate, (2) drying the resin paste to effect B-staging of the resin, (3) mounting a semiconductor chip on the B-staged resin, and (4) conducting post-curing of the resin.

## Description

### TECHNICAL FIELD

The present invention relates to a resin paste for a die bonding that is used as a bonding material (a die bonding material) between a semiconductor element such as an IC or LSI, and a support member such as a lead frame or insulating support substrate, and also relates to a method of producing a semiconductor device and a semiconductor device and the like that use such a resin paste.

### BACKGROUND ART

Conventional bonding materials for fixing an IC or LSI to a lead frame include Au-Si eutectic alloys, solders, or silver pastes.
The applicants of the present invention have previously proposed an adhesive film that uses a specific polyimide resin, and adhesive films for die bonding in which a conductive filler or an inorganic filler is added to a specific polyimide resin (see Japanese Patent Laid-Open Publication No. H07-228697, Japanese Patent Laid-Open Publication No. H06-145639, and Japanese Patent Laid-Open Publication No. H06-264035).

Although the Au-Si eutectic alloys described above offer excellent heat resistance and moisture resistance, they also have high elastic modulus values, and are consequently prone to cracking when used with large chips. Furthermore, they also have the drawback of being expensive.
Although solders are cheap, they exhibit poor heat resistance, and also have high elastic modulus values similar to those of Au-Si eutectic alloys, making them unsuitable for use with large chips. Silver pastes are cheap, exhibit a high level of moisture resistance, offer the lowest elastic modulus values amongst these conventional materials, and also have sufficient heat resistance to enable use with a 350°C thermocompression wire bonder, and as a result, are currently the most commonly used die bonding materials. However, as the level of integration of IC and LSI chips increases, leading to increases in chip size, attempts to bond IC or LSI chips to lead frames using silver paste require the paste to be applied and spread across the entire chip surface, and this leads to significant difficulties.

The adhesive film for die bonding previously proposed by the applicants of the present invention enables bonding to be conducted at comparatively low temperatures and also displays favorable adhesive strength upon heating, and can consequently be favorably employed for die bonding to 42-alloy lead frames.
However, as modem packages have become smaller and more lightweight, the use of insulating support substrates has become more widespread, and in order to reduce production costs, methods that aim to supply the die bonding material using a printing method that offers favorable applicability to mass production are garnering much attention. Against this background, in order to supply and affix the above adhesive film to insulating support substrates in an efficient manner, the film must be cut (or punched out) to chip size prior to adhesion.
Methods in which the adhesive film is cut out prior to bonding to a substrate require a bonding device to improve the production efficiency. Furthermore, methods in which the adhesive film is punched out and then affixed to a plurality of chips in a single batch operation tend to be prone to wastage of the adhesive film. Moreover, because the majority of insulating support substrates comprise inner layer wiring formed within the substrate, the surface to which the adhesive film is bonded is very uneven, and this can lead to the generation of air gaps when the adhesive film is bonded, increasing the likelihood of a deterioration in reliability.

### DISCLOSURE OF INVENTION

An object of the present invention is to provide a resin paste for die bonding that can be supplied and applied easily by a printing method to substrates that require semiconductor chips to be bonded at comparatively low temperatures. Furthermore, the present invention also provides a method of producing a semiconductor device, and a semiconductor device and the like that use such a resin paste for die bonding.

In order to achieve the above object, the present invention adopts the configuration described below. Namely, the present invention relates to a resin paste for die bonding comprising a butadiene homopolymer or copolymer (A) having a carboxylic acid terminal group, a thermosetting resin (B), a filler (C), and a printing solvent (D), wherein the elastic modulus of the resin paste following drying and curing is within a range from 1 to 300 MPa (25°C).

Another aspect of the present invention relates to a method of producing a semiconductor device that uses the above resin paste for die bonding, comprising (1) applying a predetermined quantity of the above resin paste for die bonding to a substrate, (2) drying the resin paste to effect B-staging of the resin, (3) mounting a semiconductor chip on the B-staged resin, and (4) conducting post-curing of the resin.
Another aspect of the present invention relates to a semiconductor device obtained using a production method that comprises (1) applying a predetermined quantity of the above resin paste for die bonding to a substrate, (2) drying the resin paste to effect B-staging of the resin, (3) mounting a semiconductor chip on the B-staged resin, and (4) conducting post-curing of the resin.

Another aspect of the present invention relates to a method of producing a semiconductor device, comprising (1) applying a predetermined quantity of the above resin paste for die bonding to a substrate, (2) mounting a semiconductor chip on the resin paste, and (3) curing the resin within the resin paste.
Yet another aspect of the present invention relates to a semiconductor device obtained using a method of producing a semiconductor device that comprises (1) applying a predetermined quantity of the above resin paste for die bonding to a substrate, (2) mounting a semiconductor chip on the resin paste, and (3) curing the resin within the resin paste.

### BRIEF DESCRIPTION OF THE DRAWINGS

[Figure 1]

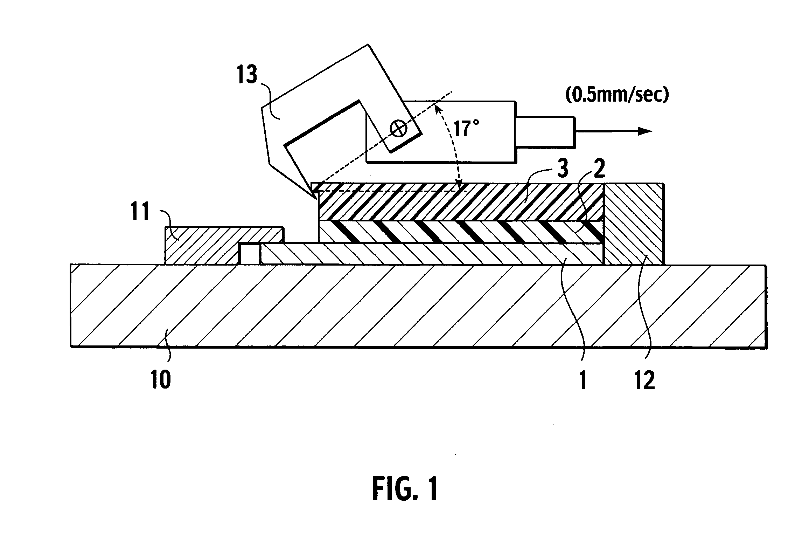

   Fig. 1 is a schematic cross-sectional view of an apparatus for measuring peel adhesive strength.

### BEST MODE FOR CARRYING OUT THE INVENTION

As follows is a more detailed description of the present invention.
A resin paste for die bonding according to the present invention (hereafter also abbreviated as simply "resin paste") comprises a butadiene polymer (a homopolymer or copolymer) (A) having a carboxylic acid terminal group, a thermosetting resin (B), a filler (C), and a printing solvent (D).

Examples of compounds that can be used favorably as the butadiene homopolymer or copolymer having a carboxylic acid terminal group, which functions as the component (A), include low molecular weight liquid polybutadienes in which an acrylonitrile has been introduced into the principal chain and with carboxylic acid groups at the terminals, such as Hycer CTB-2009×162, CTBN-1300x31, CTBN-1300x8, CTBN-1300x13, and CTBNX-1300×9 (all of which are manufactured by Ube Industries, Ltd.), and low molecular weight liquid polybutadienes having a carboxylic acid group, such as Nisso-PB-C-2000 (manufactured by Nippon Soda Co., Ltd.). These compounds can be used either alone, or in combinations of two or more different materials.

Examples of preferred thermosetting resins for the component (B) include epoxy resins, and resin mixtures comprising an epoxy resin, a phenolic resin or a compound containing a phenolic hydroxyl group within the molecule, and a curing accelerator may also be used.
The epoxy resin comprises at least 2 epoxy groups within each molecule, and from the viewpoints of curability and the properties of the cured product, a phenol glycidyl ether-based epoxy resin is preferred. Specific examples of such resins include condensation products of bisphenol A, bisphenol AD, bisphenol S, bisphenol F or a halogenated bisphenol A with epichlorohydrin, glycidyl ethers of phenol novolac resins, glycidyl ethers of cresol novolac resins, and glycidyl ethers of bisphenol A novolac resins. These compounds can be used either alone, or in combinations of two or more different compounds.
When used, the blend quantity of the epoxy resin is typically no greater than 300 parts by weight, and preferably no greater than 200 parts by weight, per 100 parts by weight of the aforementioned component (A). If this blend quantity exceeds 300 parts by weight, then the storage stability of the paste tends to be prone to deterioration.

The phenolic resin comprises at least 2 phenolic hydroxyl groups within each molecule, and suitable examples include phenol novolac resins, cresol novolac resins, bisphenol A novolac resins, poly-p-vinylphenol, and phenol aralkyl resins. These compounds can be used either alone, or in combinations of two or more different compounds.
The blend quantity of the phenolic resin or compound containing a phenolic hydroxyl group within the molecule is preferably within a range from 0 to 150 parts by weight, and even more preferably from 0 to 120 parts by weight, per 100 parts by weight of the epoxy resin. If this blend quantity exceeds 150 parts by weight, then there is a danger that the curability may be inadequate.

The curing accelerator may be any material used for curing epoxy resins. Examples of such materials include imidazoles, dicyandiamide derivatives, dicarboxylic acid dihydrazides, triphenylphosphine, tetraphenylphosphonium tetraphenylborate, 2-ethyl-4-methylimidazole tetraphenylborate, and 1,8-diazabicyclo(5,4,0)undecene-7-tetraphenylborate. Combinations of two or more of these compounds may also be used.
The quantity of the curing accelerator is preferably within a range from 0 to 50 parts by weight, and even more preferably from 0 to 20 parts by weight, per 100 parts by weight of the epoxy resin. If this blend quantity exceeds 50 parts by weight, then there is a danger of a deterioration in the storage stability of the paste.

An imide compound containing at least 2 thermosetting imide groups within each molecule can be used as the thermosetting resin (B). Examples of such compounds include ortho-bismaleimidobenzene, meta-bismaleimidobenzene, para-bismaleimidobenzene, 1,4-bis(p-maleimidocumyl)benzene, and 1,4-bis(m-maleimidocumyl)benzene. These compounds can be used either alone, or in combinations of two or more different compounds. Moreover, the use of imide compounds represented by the formulas (I) through (III) shown below is also preferred.

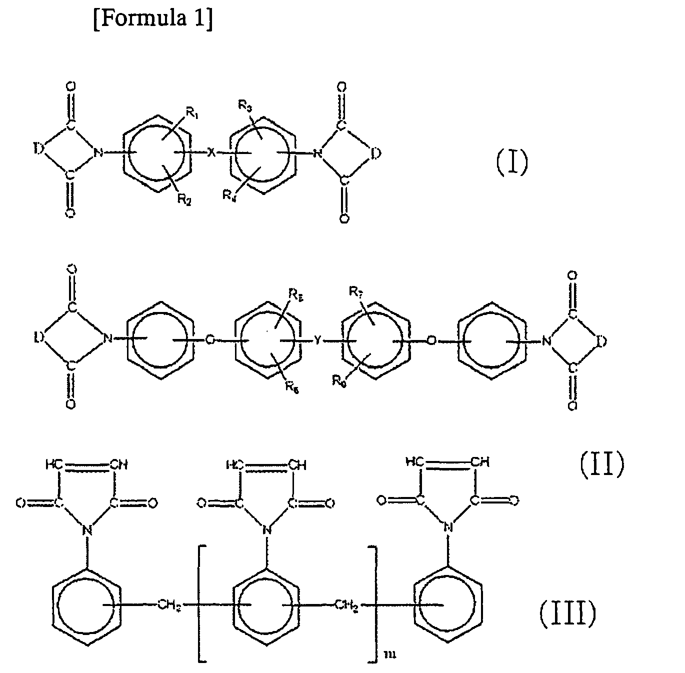

(in the formulas, X and Y represent O, CH₂, CF₂, SO₂, S, CO, C(CH₃)₂ or C(CF₃)₂; R₁, R₂, R₃, R₄, R₅, R₆, R₇ and R₈ each represent, independently, a hydrogen atom, lower alkyl group, lower alkoxy group, or a fluorine, chlorine or bromine atom; D represents a dicarboxylic acid residue that contains an ethylenic double bond; and m represents an integer from 0 to 4)

When used, the blend quantity of the imide compound is typically no greater than 200 parts by weight, and preferably no greater than 100 parts by weight, per 100 parts by weight of the component (A). If this blend quantity exceeds 200 parts by weight, then the storage stability of the paste tends to be prone to deterioration.

Specific examples of the imide compounds of the formula (I) include 4,4-bismaleimidodiphenyl ether, 4,4-bismaleimidodiphenylmethane, 4,4-bismaleimido-3,3'-dimethyl-diphenylmethane, 4,4-bismaleimidodiphenyl sulfone, 4,4-bismaleimidodiphenyl sulfide, 4,4-bismaleimidodiphenyl ketone, 2,2'-bis(4-maleimidophenyl)propane, 4,4-bismaleimidodiphenylfluoromethane, and 1,1,1,3,3,3,-hexafluoro-2,2-bis(4-maleimidophenyl)propane.

Specific examples of the imide compounds of the formula (II) include bis[4-(4-maleimidophenoxy)phenyl] ether, bis[4-(4-maleimidophenoxy)phenyl]methane, bis[4-(4-maleimidophenoxy)phenyl]fluoromethane, bis[4-(4-maleimidophenoxy)phenyl] sulfone, bis[4-(3-maleimidophenoxy)phenyl] sulfone, bis[4-(4-maleimidophenoxy)phenyl] sulfide, bis[4-(4-maleimidophenoxy)phenyl] ketone, 2,2-bis[4-(4-maleimidophenoxy)phenyl]propane, and 1,1,1,3,3,3-hexafluoro-2,2-bis[4-(4-maleimidophenoxy)phenyl]propane.

In order to accelerate the curing of these imide compounds, a radical polymerization agent may be used. Examples of suitable.radical polymerization agents include acetylcyclohexylsulfonyl peroxide, isobutyryl peroxide, benzoyl peroxide, octanoyl peroxide, acetyl peroxide, dicumyl peroxide, cumene hydroperoxide, and azobisisobutyronitrile. The quantity used of the radical polymerization agent is preferably within a range from approximately 0.01 to 1.0 parts by weight per 100 parts by weight of the imide compound.

Examples of the filler of the component (C) include conductive (metal) fillers such as silver powder, gold powder and copper powder; and inorganic fillers such as silica, alumina, titania, glass, iron oxide, and ceramics.
Of these fillers, conductive (metal) fillers such as silver powder, gold powder and copper powder are added for the purposes of imparting conductivity, thermal conductivity, or thixotropic properties to the adhesive. Furthermore, inorganic fillers such as silica, alumina, titania, glass, iron oxide, and ceramics are added for the purposes of imparting low thermal expansion characteristics, a low moisture absorptivity, and thixotropic properties to the adhesive. These fillers can be used either alone, or in combinations of two or more different fillers.

An inorganic ion exchange material may be added as a filler capable of improving the electrical reliability of the semiconductor device. Materials that exhibit an ion scavenging action on ions such as Na⁺, K⁺, Cl⁻, F, RCOO⁻ and Br⁻ that are eluted into an aqueous solution when a cured product of the paste is extracted in hot water are effective as the inorganic ion exchange material. Examples of this type of ion exchange material include naturally occurring minerals such as naturally produced zeolites, acid clays, dolomites and hydrotalcites, as well as synthetic zeolites that have been synthesized artificially.

These conductive fillers or inorganic fillers can also be used in mixtures of two or more materials. Furthermore, mixtures of one or more conductive fillers and one or more inorganic fillers may also be used, provided they do not impair the physical properties of the product.
Typically, the quantity of the filler is preferably within a range from 1 to 100 parts by weight, and even more preferably from 2 to 50 parts by weight, per 100 parts by weight of the component (A). From the viewpoint of imparting satisfactory thixotropic properties (a thixotropic index of at least 1.5) to the paste, the quantity of this filler is preferably at least 1 part by weight. Furthermore from the viewpoint of adhesion, the quantity of this filler is preferably no greater than 100 parts by weight, and if a blend quantity that exceeds this value is used, then the elastic modulus of the cured product increases, which causes the stress relaxation capabilities of the die bonding material to weaken, increasing the danger of a deterioration in the reliability of the mounting within the semiconductor device.
Mixing and kneading of the filler is conducted using a suitable combination of typical stirring devices, and dispersion devices such as stone mills, three-roll mills and ball mills.

The printing solvent of the component (D) is preferably selected from amongst those solvents that are capable of uniformly kneading or dispersing the filler. Moreover, considering the need to prevent volatilization of the solvent during printing, the selection of a solvent with a boiling point of at least 100°C is preferred.
Examples of the printing solvent include N-methyl-2-pyrrolidinone, diethylene glycol dimethyl ether (also known as diglyme), triethylene glycol dimethyl ether (also known as triglyme), diethylene glycol diethyl ether, 2-(2-methoxyethoxy)ethanol, γ-butyrolactone, isophorone, carbitol, carbitol acetate, 1,3-dimethyl-2-imidazolidinone, 2-(2-butoxyethoxy)ethyl acetate, ethyl cellosolve, ethyl cellosolve acetate, butyl cellosolve, dioxane, cyclohexanone and anisole, as well as solvents comprising mainly petroleum distillates, which are used as the solvents for printing inks. Mixtures of two or more of these solvents may also be used.
The blend quantity of the printing solvent (D) is typically within a range from 10 to 100 parts by weight per 100 parts by weight of the component (A).

Furthermore, in those cases where the generation of foam or voids is noticeable during printing of the resin paste, the addition of defoaming agents, foam breakers or foam suppressants to the above printing solvent (D) is effective. From the viewpoint of achieving a favorable foam suppression effect, the quantity added of these materials is preferably at least 0.01% by weight of the solvent (D), whereas from the viewpoints of achieving favorable adhesion and viscosity stability for the paste, the quantity is preferably no greater than 10% by weight of the solvent (D).
Furthermore, in order to improve the adhesive strength, silane coupling agents, titanium-based coupling agents, nonionic surfactants, fluorine-based surfactants and silicone-based additives may also be added to the resin paste.

The elastic modulus following drying and curing of the resin paste that comprises the types of components described above, that is, the elastic modulus of a cured product of the paste, falls within a range from 1 to 300 MPa (25°C). This elastic modulus following drying and curing is preferably within a range from 1 to 100 MPa (25°C).
The above elastic modulus is the value at 25°C obtained when the storage elastic modulus E' of the paste cured product is measured using a dynamic viscoelasticity measurement apparatus. If the elastic modulus of the resin paste following drying and curing is less than 1, then the substrate and the chip tend to be prone to misalignment, and the assembly operation becomes undesirably difficult, whereas if the elastic modulus exceeds 300 MPa, then the stress relaxation between the substrate and the chip is inadequate, and the resistance of the semiconductor package to temperature cycling deteriorates. The term "following drying and curing" refers to the state following complete curing of the resin.

In addition, the solid fraction of the resin paste is preferably within a range from 40 to 90% by weight. Ensuring that this solid fraction is at least 40% by weight is preferred from the viewpoint of suppressing shape variations caused by volumetric shrinkage of the paste following drying, whereas ensuring a solid fraction of no more than 90% by weight is preferred from the viewpoint of improving the fluidity and printing operability of the paste.

The thixotropic index of the resin paste is preferably within a range from 1.5 to 8.0. Ensuring that the thixotropic index is at least 1.5 is preferred from the viewpoint of ensuring a more favorable printing shape by suppressing the occurrence of running or the like of the paste that has been supplied and applied using a printing method. Moreover, ensuring that the thixotropic index is no more than 8.0 is preferred from the viewpoint of suppressing the occurrence of chipping or patchy coverage, etc. of the paste that has been supplied and applied using a printing method.

The viscosity (25°C) of the resin paste is preferably within a range from 5 to 1,000 Pa·s. Ensuring the viscosity is from 5 to 1,000 Pa·s is preferred from the viewpoint of printing operability. The viscosity of the resin paste is preferably suitably adjusted in accordance with the nature of the printing method, and for example in the case where a mesh or the like is stretched across the mask openings, such as the case of a screen mesh, then considering the ability of the paste to pass through the mesh, the viscosity of the resin paste is preferably within a range from 5 to 100 Pa·s, whereas in the case of a stencil or the like, the viscosity is preferably adjusted to a value within a range from 20 to 500 Pa·s. Furthermore, in those cases where large quantities of residual voids are observed within the paste following drying, adjusting the viscosity to no more than 150 Pa·s is effective.

The viscosity mentioned above refers to the value measured at 25°C using an E-type rotational viscometer, with a rotation rate of 0.5 rpm. Furthermore, the thixotropic index is defined as the ratio between the viscosity value measured at 25°C using an E-type rotational viscometer with a rotation rate of 1 rpm, and the viscosity value measured at a rotation rate of 10 rpm (thixotropic index = (viscosity at 1 rpm)/(viscosity at 10 rpm)).

The obtained resin paste for die bonding can be supplied and applied, by a printing method, to a lead frame such as a 42-alloy lead frame or copper lead frame; a plastic film of a polyimide resin, epoxy resin or polyimide-based resin; a substrate comprising a base material such as a nonwoven glass cloth into which a plastic such as a polyimide resin, epoxy resin or polyimide-based resin has been impregnated and then cured; or a support member formed from a ceramic such as alumina, and subsequently dried and semi-cured (B-staged). This process yields a support substrate coated with a B-stage adhesive. A semiconductor element (chip) such as an IC or LSI is affixed to this B-stage adhesive-coated support substrate, and heat is then applied to bond the chip to the support substrate. Subsequently, post-curing of the resin paste is conducted to complete the mounting of the chip on the support substrate. This post-curing of the resin paste may be combined with the post-curing step of the sealing material, provided no problems arise within the mounting and assembly processes.
A method of producing a semiconductor device according to the present invention comprises each of the steps described above, and a semiconductor device according to the present invention is produced using a production method that comprises each of the steps described above.

Although the above resin paste for die bonding contains a solvent, when the paste is used in the method of producing a semiconductor device, the majority of the solvent is volatilized by the B-staging that occurs in the drying step, meaning that a semiconductor device with favorable mounting reliability and a minimal level of voids within the die bonding layer can be assembled.

On the other hand, following supply and application of the resin paste using a printing method, the semiconductor element may also be affixed to the support substrate without drying and semi-curing the paste, and heat then applied to bond the chip to the support substrate, provided the package reliability is unaffected.
Accordingly, a method of producing a semiconductor device according to another aspect of the present invention comprises applying a predetermined quantity of the above resin paste for die bonding to a substrate, mounting a semiconductor chip on the resin paste, and curing the resin within the resin paste, and a semiconductor device according to another aspect of the present invention is a device produced using the production method that comprises each of the above steps.

### EXAMPLES

As follows is a description of specifics of the present invention based on a series of examples.

### (Example 1)

100 parts by weight of CTBNX-1300x9 (manufactured by Ube Industries, Ltd.) was weighed and placed inside a stone mill as the butadiene homopolymer or copolymer (A) having a carboxylic acid terminal group (the base resin). To this resin were added a previously prepared solution comprising 25 parts by weight of an epoxy resin (YDCH-702) and 15 parts by weight of a phenolic resin (H-1) as the thermosetting resin (B) dissolved in carbitol acetate (60 parts by weight) as the printing solvent (D) (the solid fraction concentration of the thermosetting resin was approximately 40% by weight), and 0.5 parts by weight of a curing accelerator (TPPK), and the resulting composition was mixed. Subsequently, 8 parts by weight of a finely powdered silica Aerosil was added as the filler (C), and the resulting mixture was stirred and kneaded for 1 hour, yielding a resin paste for die bonding (resin paste No. 1; solid fraction: 71.2% by weight).

### (Examples 2 to 5, Comparative Example 1)

The nature and blend quantities of the base resin, thermosetting resin, filler and/or solvent were altered, and preparation was conducted in the same manner as the example 1, yielding a series of resin pastes for die bonding (resin pastes No. 2 through No. 6; solid fractions (in order): 68.3, 72.5, 65.5, 67.3, 44.5% by weight; the resin paste No. 6 was for comparative purposes).
The respective compositions of these resin pastes are shown in Table 1.

**[Table 1]**

| Material (The bottom line shows parts by weight) | Example 1 | Example 2 | Example 3 | Example 4 | Example 5 | Comparative example 1 |
|---|---|---|---|---|---|---|
| | Resin paste No. 1 | Resin paste No. 2 | Resin paste No. 3 | Resin paste No. 4 | Resin paste No. 5 | Resin paste No. 6 |
| Base resin | CTBNX-1300x9 100 | CTBN-1300x31 100 | CTBNX-1300x9 100 | CTBNX-1300x9 100 | CTBN-1300x8 100 | - |
| Epoxy resin | YDCH-702 25 | YDCH-702 25 | ESCN-195 25 | ESCN-195 39 | YDCH-702 40 | ESCN-195 100 |
| Phenolic resin | H-1 15 | VH-4170 17 | H-1 15 | H-1 21 | H-1 15 | H-1 53 |
| Curing accelerator | TPPK 0.5 | TPPK 1.0 | 2P4MHZ 1.0 | 2P4MHZ 1.0 | 2P4MHZ 1.0 | 2P4MHZ 1.0 |
| Filler | Aerosil 8 | Aerosil 8 | Aerosil 17 | Aerosil 10 | Aerosil 15 | Aerosil 31 |
| Solvent | CA 60 | NMP 70 | CA 60 | NMP 90 | NMP 83 | NMP 231 |

In Table 1, the various reference symbols refer to the materials described below.
CTBNX-1300x9: a carboxylic acid-terminated liquid polybutadiene (number of functional groups: 2.3/mol), manufactured by Ube Industries, Ltd.
CTBN-1300x31: a carboxylic acid-terminated liquid polybutadiene (number of functional groups: 1.9/mol), manufactured by Ube Industries, Ltd.
CTBN-1300×8: a carboxylic acid-terminated liquid polybutadiene (number of functional groups: 1.85/mol), manufactured by Ube Industries, Ltd.
YDCH-702: a cresol novolac-based epoxy resin (epoxy equivalence: 220), manufactured by Tohto Kasei Co., Ltd.
ESCN-195: a cresol novolac-based epoxy resin (epoxy equivalence: 200), manufactured by Nippon Kayaku Co., Ltd.
H-1: a phenol novolac resin (OH equivalence: 106), manufactured by Meiwa Plastic Industries, Ltd.
VH-4170: a bisphenol A novolac resin (OH equivalence: 118), manufactured by Dainippon Ink and Chemicals, Incorporated.
TPPK: tetraphenylphosphonium tetraphenylborate, manufactured by Tokyo Chemical Industry Co., Ltd.
2P4MHZ: Curezol (an imidazole compound), manufactured by Shikoku Chemicals Corporation.
Aerosil: Aerosil #380 (finely powdered silica), manufactured by Nippon Aerosil Co., Ltd.
CA: carbitol acetate
NMP: N-methyl-2-pyrrolidone

The viscosity and thixotropic index of each of the resin pastes for die bonding following blending and mixing are shown in Table 2. The methods used for measuring the viscosity and thixotropic index are as described below.
Viscosity: the viscosity of the resin paste at 25°C was measured with an E-type viscometer manufactured by Toki Sangyo Co., Ltd, using a diameter of 19.4 mm and a 3° cone (0.5 rpm).
Thixotropic Index: the viscosity at each rotation rate was measured using the above viscometer, and the thixotropic index was then calculated using the following formula: Thixotropic index = (viscosity at 1 rpm) / (viscosity at 10 rpm)

For each of the obtained resin pastes, the peel adhesive strength was measured for chip bonding temperatures of 180°C and 250°C. The method of measuring the peel adhesive strength is described below.
The resin paste was printed onto an organic substrate that had been coated with a solder resist PSR-4000AUS manufactured by Taiyo Ink Mfg. Co., Ltd. (the step (1) of applying a predetermined quantity of the paste to a substrate), and following drying for 15 minutes at 60°C and then 30 minutes at 100°C (the step (2) of effecting B-staging via a drying process), a silicon chip of dimensions 5 mm × 5 mm was pressed onto the resin paste for 5 seconds using a 1,000 g load, with the substrate sitting on a hotplate at either 180°C or 250°C (the step (3) of mounting a semiconductor chip on the B-staged resin for die bonding). The silicon chip was prepared by half cutting a 400 µm thick wafer to a thickness of 250 µm, and then splitting the wafer by applying force to the underside, thus forming a chip with protrusions of thickness 150 µm at the edges. Subsequently, following curing for one hour at 180°C (the step (4) of post-curing), the measurement apparatus shown in Fig. 1 was used to measure the peel strength upon heating at 250°C for 20 seconds.
The measurement apparatus shown in Fig. 1 is an improved push-pull gauge, wherein a laminate comprising a substrate 1, a die bonding material (the resin paste) 2, and a silicon chip 3 is secured on top of a hotplate 10 using supports 11 and 12, a push-pull gauge 13 is hooked under a protrusion of the silicon chip 3, and the chip peel strength for the resin paste is then measured by detecting the loading when the push-pull gauge 13 is moved in the direction of the arrow shown in the figure. In general, higher numerical values indicate a reduced likelihood of reflow cracking.

As shown in Table 2, the resin pastes No. 1 through 5 exhibited a high level of peel adhesive strength at both 180°C and 250°C. Furthermore, the heat resistance was also excellent.

The degree of chip warping when a silicon chip was bonded to a lead frame using each of the resin pastes obtained in No. 1 through 6 was also measured. The measurement of the chip warping was conducted in the manner described below.
The resin paste was printed onto an EF-TEC64T copper plate of thickness 150 *µ*m manufactured by Furukawa Electric Co., Ltd., and was then dried for 15 minutes at 60°C and then 30 minutes at 100°C, thus forming a die bonding material (a resin paste for die bonding) with a film thickness of 40 µm. A silicon chip with dimensions of 13 mm × 13 mm and a thickness of 400 *µ*m was then placed on top of the die bonding material, a load of 1,000 g was applied, and the chip was subjected to thermocompression bonding for 5 seconds at 250°C. Following cooling to room temperature (25°C), a surface roughness meter was used to scan the chip across 11 mm in a straight line, and the maximum height (µm) from the baseline was determined and used as the chip warping value.

As shown in Table 2, the chip warping in those cases that used the resin pastes of No. 1 through 3 was almost zero, indicating a favorable stress relaxation capability. The chip warping in those cases that used the resin pastes of No. 4 and 5 was higher than that observed for No. 1 through 3, but was still 1/3 or less than that observed for the resin paste of the (comparative) No. 6, indicating a satisfactory stress relaxation capability.

The storage elastic modulus values E' of the films following curing were measured using a dynamic viscoelasticity measurement apparatus, and are shown in Table 2. The measurement method used is described below.
The resin paste for die bonding was applied to a polytetrafluoroethylene film, in sufficient quantity to form a cured film thickness of 100 µm, and was then subjected to preliminary drying for 60 minutes at 150°C, and then curing for 60 minutes at 180°C. The cured film was then peeled off the polytetrafluoroethylene film, and the storage elastic modulus was measured under the following conditions, and recorded as a 25°C value.
Film thickness: 100 µm, film width: 8 mm, length of measured portion: 22.6 mm, measurement frequency: 1 Hz, measurement temperature: -100°C to 300°C, rate of temperature increase: 5°C/min., measurement atmosphere: N₂, measurement apparatus: viscoelasticity analyzer RSA-2, manufactured by Rheometric Scientific FE, Ltd.

**[Table 2]**

| Resin paste | | Viscosity (Pa·s) | Thixotropic index | Peel adhesive strength (N/chip) | | Chip warping (µm) | Storage elastic modulus (MPa) |
|---|---|---|---|---|---|---|---|
| | | | | 180°C | 250°C | | |
| No. 1 | Example 1 | 160 | 3.3 | 22 | 25 | 0 | 7 |
| No. 2 | Example 2 | 50 | 3 | 19 | 30 | 0 | 8 |
| No. 3 | Example 3 | 150 | 4.8 | 20 | 20 | 1 | 15 |
| No. 4 | Example 4 | 30 | 4 | 35 | 30 | 15 | 230 |
| No.5 | Example 5 | 200 | 5 | 40 | 32 | 17 | 240 |
| No. 6 | Comparative example 1 | 30 | 3.4 | 5 | 5 | 59 | Brittle, film formation impossible |

A resin paste for die bonding according to the present invention exhibits excellent low stress properties, and excellent adhesive strength upon heating.
According to the present invention, a resin paste for die bonding can be provided that is able to be supplied and applied easily by a printing method to substrates that require semiconductor chips to be bonded at comparatively low temperatures. Furthermore, a resin paste for die bonding according to the present invention exhibits favorable heat resistance, is easy to handle, and exhibits excellent low stress properties and low temperature adhesion. Moreover, because the resin paste offers improved adhesion to substrates compared with film-like adhesives, the package reliability also improves. The resin paste can be used favorably for the die bonding of insulating support substrates such as organic substrates and copper lead frames, and can also be used with 42-alloy lead frames.

This Application is based upon and claims the benefit of priority from prior Japanese Application 2004-180959 filed on June 18, 2004, the entire contents of which are incorporated by reference herein.
It should be noted that, besides those already mentioned above, various modifications and variations can be made in the aforementioned embodiments without departing from the novel and advantageous features of the present invention. Accordingly, it is intended that all such modifications and variations are included within the scope of the appended claims.

## Claims

1. A resin paste for die bonding, comprising a butadiene homopolymer or copolymer (A) having a carboxylic acid terminal group, a thermosetting resin (B), a filler (C), and a printing solvent (D), wherein an elastic modulus of the resin paste following drying and curing is within a range from 1 to 300 MPa (25°C).

2. The resin paste for die bonding according to claim 1, wherein a solid fraction is within a range from 40 to 90% by weight, a thixotropic index is within a range from 1.5 to 8.0, and a viscosity (25°C) is within a range from 5 to 1,000 Pa·s.

3. A method of producing a semiconductor device, comprising (1) applying a predetermined quantity of the resin paste for die bonding according to either claim 1 or 2 to a substrate, (2) drying the resin paste to effect B-staging of the resin, (3) mounting a semiconductor chip on the B-staged resin, and (4) conducting post-curing of the resin.

4. A semiconductor device, obtained using the method of producing a semiconductor device according to claim 3.

5. A method of producing a semiconductor device, comprising (1) applying a predetermined quantity of the resin paste for die bonding according to either claim 1 or 2 to a substrate, (2) mounting a semiconductor chip on the resin paste, and (3) curing the resin within the resin paste.

6. A semiconductor device, obtained using the method of producing a semiconductor device according to claim 5.
